(19) **Europäisches Patentamt / European Patent Office / Office européen des brevets**

(11) **EP 3 279 893 B1**

(12) **EUROPEAN PATENT SPECIFICATION**

(45) Date of publication and mention of the grant of the patent:
**22.09.2021 Bulletin 2021/38**

(51) Int Cl.:
**G10L 19/008** *(2013.01)* **G10L 19/02** *(2013.01)*

(21) Application number: **17193794.9**

(22) Date of filing: **15.08.2005**

(54) **TEMPORAL ENVELOPE SHAPING FOR SPATIAL AUDIO CODING USING FREQUENCY DOMAIN WIENER FILTERING**

FORMUNG DER ZEITLICHEN ENVELOPE ZUR RÄUMLICHEN AUDIOCODIERUNG UNTER VERWENDUNG VON FREQUENZBEREICHS-WIENER-FILTERUNG

CONFIGURATION D'ENVELOPPE TEMPORELLE POUR CODAGE AUDIO SPATIAL PAR FILTRAGE DE WIENER DU DOMAINE DE FREQUENCE

(84) Designated Contracting States:
**AT BE BG CH CY CZ DE DK EE ES FI FR GB GR HU IE IS IT LI LT LU LV MC NL PL PT RO SE SI SK TR**

(30) Priority: **25.08.2004 US 604836 P**

(43) Date of publication of application:
**07.02.2018 Bulletin 2018/06**

(62) Document number(s) of the earlier application(s) in accordance with Art. 76 EPC:
**05786297.1 / 1 784 818**

(73) Proprietor: **Dolby Laboratories Licensing Corporation**
**San Francisco, CA 94103-1410 (US)**

(72) Inventors:
- **VINTON, Mark Stuart**
  **San Francisco, CA California 94103-1410 (US)**
- **SEEFELDT, Alan Jeffrey**
  **San Francisco, CA California 94103-1410 (US)**

(74) Representative: **Dolby International AB**
**Patent Group Europe**
**Apollo Building, 3E**
**Herikerbergweg 1-35**
**1101 CN Amsterdam Zuidoost (NL)**

(56) References cited:
**US-A- 5 812 971     US-A1- 2003 195 742**
**US-B1- 6 502 069**

- SCHUIJERS E, OOMEN W, DEN BRINKER B, BREEBART J: "Advances in Parametric Coding for High-Quality Audio", AUDIO ENGINEERING SOCIETY 114TH CONVENTION, no. 5852, 22 March 2003 (2003-03-22), pages 1-11, XP002365269, Amsterdam, Netherlands
- HERRE J, PURNHAGEN H, BREEBAART J, FALLER C, DISCH S, KJÖRLING K, SCHUIJERS E, HILPERT J, MYBURG F: "The Reference Model Architecture for MPEG Spatial Audio Coding", AUDIO ENGINEERING SOCIETY 118TH CONVENTION, no. 6447, 28 May 2005 (2005-05-28), pages 1-13, XP002365270, Barcelona, Spain

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

*Field of the Invention*

The present invention relates to block-based audio coders in which the audio information, when decoded, has a temporal envelope resolution limited by the block rate, including perceptual and parametric audio encoders, decoders, and systems, to corresponding methods, to computer programs for implementing such methods, and to a bitstream produced by such encoders.

*Background of the Invention*

Many reduced-bit-rate audio coding techniques are "block-based" in that the encoding includes processing that divides each of the one or more audio signals being encoded into time blocks and updates at least some of the side information associated with the encoded audio no more frequently than the block rate. As a result, the audio information, when decoded, has a temporal envelope resolution limited by the block rate. Consequently, the detailed structure of the decoded audio signals over time is not preserved for time periods smaller than the granularity of the coding technique (typically in the range of 8 to 50 milliseconds per block).

Such block-based audio coding techniques include not only well-established perceptual coding techniques known as AC-3, AAC, and various forms of MPEG in which discrete channels generally are preserved through the encoding/decoding process, but also recently-introduced limited bit rate coding techniques, sometimes referred to as "Binaural Cue Coding" and "Parametric Stereo Coding," in which multiple input channels are downmixed to and upmixed from a single channel through the encoding/decoding process. Details of such coding systems are contained in various documents, including those cited below under the heading "Background Art". As a consequence of the use of a single channel in such coding systems, the reconstructed output signals are, necessarily, amplitude scaled versions of each other - for a particular block, the various output signals necessarily have substantially the same fine envelope structure.

Although all block-based audio coding techniques may benefit from an improved temporal envelope resolution of their decoded audio signals, the need for such improvement is particularly great in block-based coding techniques that do not preserve discrete channels throughout the encoding/decoding process. Certain types of input signals, such as applause, for example, are particularly problematic for such systems, causing the reproduced perceived spatial image to narrow or collapse.

*Brief Description of the Drawings*

FIG. 1 is a schematic functional block diagram of an encoder or encoding function embodying aspects of the present invention.
FIG. 2 is a schematic functional block diagram of a decoder or decoding function embodying aspects of the present invention.

*Summary of the Invention*

In accordance with an aspect of the invention, a method for audio signal decoding is provided in which one or more input audio signals have been encoded into a bitstream comprising audio information and side information relating to the audio information and useful in decoding the bitstream, the encoding including processing that divides each of the one or more input audio signals into time blocks and updates at least some of the side information no more frequently than the block rate, such that the audio information, when decoded using the side information, has a temporal envelope resolution limited by the block rate, the encoding further including comparing the temporal envelope of at least one input audio signal and the temporal envelope of an estimated decoded reconstruction of each such at least one input audio signal, which estimated reconstruction employs at least some of the audio information and at least some of the side information, and the decoding further including receiving the bitstream, the decoding employing the audio information and the side information, and re-shaping the decoded audio reconstructions of the input audio signals uses the temporal envelope re-shaping information.

Another aspect includes an audio signal decoder adapted to perform the above-stated method.

*Detailed Description of the Invention*

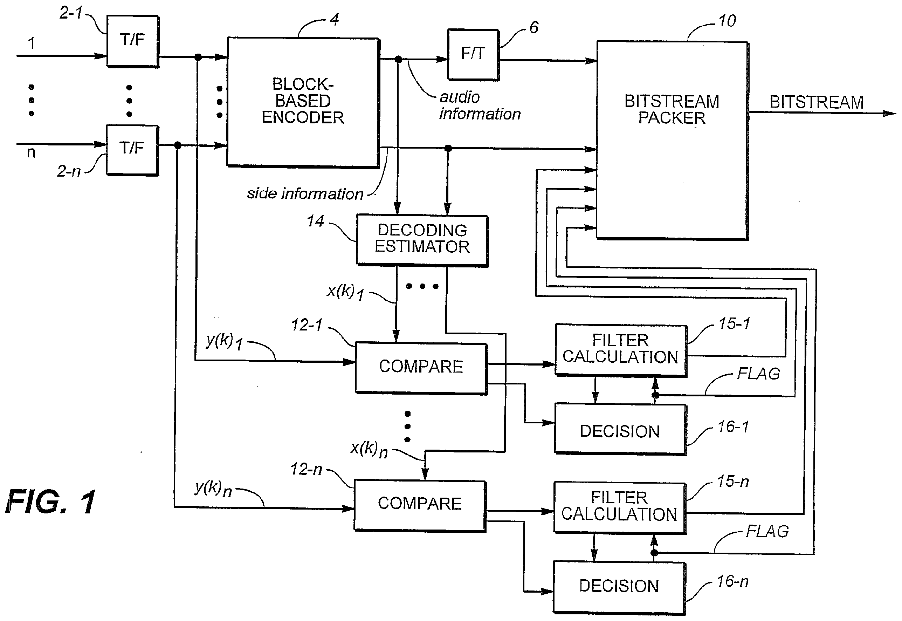

FIG. 1 shows an example of an encoder or encoding process not being part of the invention. A plurality of audio input signals such as PCM signals, time samples of respective analog audio signals, 1 through n, are applied to respective time-domain to frequency-domain converters or conversion functions ("T/F") 2-1 through 2-n. The audio signals may represent, for example, spatial directions such as left, center, right, etc. Each T/F may be implemented, for example, by dividing the input audio samples into blocks, windowing the blocks, overlapping the blocks, transforming each of the windowed and overlapped blocks to the frequency domain by computing a discrete frequency transform (DFT) and partitioning the resulting frequency spectrums into bands simulating the ear's critical bands, for example, twenty-one bands using, for example, the equivalent-rectangular band (ERB) scale. Such DFT processes are well known in the art. Other time-domain to frequency domain conversion parameters and techniques may be employed. Neither the particular parameters nor the particular technique are critical to the invention. However, for the purposes of ease in explanation, the following description assumes that such a DFT conversion technique is employed.

The frequency-domain outputs of T/F 2-1 through 2-n are each a set of spectral coefficients. These sets may be designated $Y[k]_1$ through $Y[k]_n$, respectively. All of these sets may be applied to a block-based encoder or encoder function ("block-based encoder") 4. The block-based encoder may be, for example, any one of the known block-based encoders mentioned above alone or sometimes in combination or any future block-based encoders including variations of those encoders mentioned above. Although aspects of the invention are particularly beneficial for use in connection with block-based encoders that do not preserve discrete channels during encoding and decoding, aspects of the invention are useful in connection with virtually any block-based encoder.

The outputs of a typical block-based encoder 4 may be characterized as "audio information" and "side information." The audio information may comprise data representing multiple signal channels as is possible in block-based coding systems such as AC-3, AAC and others, for example, or, it may comprise only a single channel derived by downmixing multiple input channels, such as the afore-mentioned binary cue coding and parametric stereo coding systems (the downmixed channel in a binary cue coding encoder or a parametric stereo coding system may also be perceptually encoded, for example, with AAC or some other suitable coding). It may also comprise a single channel or multiple channels derived by downmixing multiple input channels such as disclosed in U.S. Provisional Patent Application S.N. 60/588,256, filed July 14, 2004 of Davis et al, entitled "Low Bit Rate Audio Encoding and Decoding in Which Multiple Channels are Represented By Monophonic Channel and Auxiliary Information." The side information may comprise data that relates to the audio information and is useful in decoding it. In the case of the various downmixing coding systems, the side information may comprise, spatial parameters such as, for example, interchannel amplitude differences, interchannel time or phase differences, and interchannel cross-correlation.

The audio information and side information from the block-based encoder 4 may then be applied to respective frequency-domain to time-domain converters or conversion functions ("F/T") 6 and 8 that each perform generally the inverse functions of an above-described T/F, namely an inverse FFT, followed by windowing and overlap-add. The time-domain information from F/T 6 and 8 is applied to a bitstream packer or packing function ("bitstream packer") 10 that provides an encoded bitstream output. Alternatively, if the encoder is to provide a bitstream representing frequency-domain information, F/T 6 and 8 may be omitted.

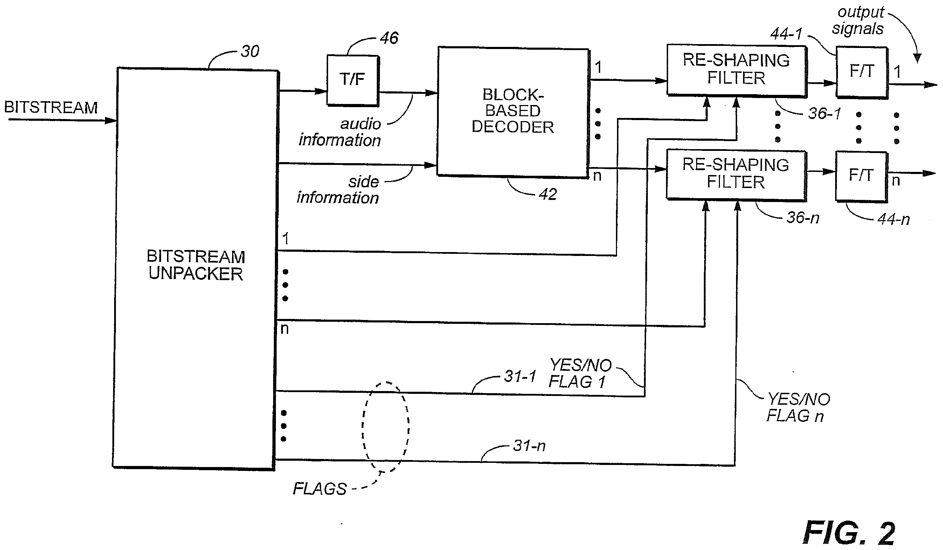

The frequency-domain audio information and side information from block-based encoder 4 are also applied to a decoding estimator or estimating function ("decoding estimator") 14. Decoding estimator 14 may simulate at least a portion of a decoder or decoding function designed to decode the encoded bitstream provided by bitstream packer 10. An example of such a decoder or decoding function is described below in connection with FIG. 2. The decoding estimator 14 may provide sets of spectral coefficients $X[k]_1$ through $X[k]_n$ that approximate the sets of spectral coefficients $X[k]_1$ through $Y[k]_n$ of corresponding input audio signals that are expected to be obtained in the decoder or decoding function. Alternatively, it may provide such spectral coefficients for fewer than all input audio signals, for fewer than all time blocks of the input audio signals, and/or for less than all frequency bands (*i.e.,* it may not provide all spectral coefficients). This may arise, for example, if it is desired to improve only input signals representing channels deemed more important than others. As another example, this may arise if it is desired to improve only the lower frequency portions of signals in which the ear is more sensitive to the fine details of temporal waveform envelopes.

Each of the frequency-domain outputs of T/F 2-1 through 2-n, the sets of spectral coefficients $X[k]_1$ through $Y[k]_n$, are each also applied to respective compare devices or functions ("compare") 12-1 through 12-n. Such sets are compared to corresponding sets of corresponding time blocks of the estimated spectral coefficients $X[k]_1$ through $X[k]_n$ in respective compare 12-1 through 12-n. The results of comparing in each compare 12-1 through 12-n are each applied to a filter calculator or calculation function ("filter calculation") 15-1 through 15-n. This information should be sufficient for each filter calculation to define the coefficients of a filter for each time block, which filter, when applied to a decoded reconstruction of an input signal, would result in the signal having a temporal envelope with an improved resolution. In other words, the filter would reshape the signal so that it more closely replicates the temporal envelope of the original signal. The improved resolution is a resolution finer than the block rate. Further details of a preferred filter are set forth below.

Although the example of FIG. 1 shows the compare and the filter calculation in the frequency domain, in principle, the compare and the filter calculation may be performed in the time domain. Whether performed in the frequency domain or time domain, only one filter configuration is determined per time block (although the same filter configuration may be applied to some number of consecutive time blocks). Although, in principle, a filter configuration may be determined on a band by band basis (such as per band of the ERB scale), doing so would require the sending of a large number of side information bits, which would defeat an advantage of the invention, namely, to improve temporal envelope resolution with a low increase in bit rate.

A measure of the comparing in each compare 12-1 through 12-n is each applied to a decision device or function ("decision") 16-1 through 16-n. Each decision compares the measure of comparing against a threshold. A measure of the comparing may take various forms and is not critical. For example, the absolute value of the difference of each corresponding coefficient value may be calculated and the differences summed to provide a single number whose value indicates the degree to which the signal waveforms differ from one another during a time block. That number may be compared to a threshold such that if it exceeds the threshold a "yes" indicator is provided to the corresponding filter calculation. In the absence of a "yes" indicator, the filter calculations may be inhibited for the block, or, if calculated, they may not be outputted by the filter calculation. Such yes/no information for each signal constitutes a flag that may also be applied to the bitstrcam packer 10 for inclusion in the bitstrcam (thus, there may be a plurality of flags, one for each input signal and each of such flags may be represented by one bit).

Alternatively, each decision 16-1 through 16-n may receive information from a respective filter calculation 14-1 through 14-n instead of or in addition to information from a respective compare 12-1 through 12-n. The respective decision 16 may employ the calculated filter characteristics (*e.g.,* their average or their peak magnitudes) as the basis for making a decision or to assist in making a decision.

As mentioned above, each filter calculation 14-1 through 14-n provides a representation of the results of comparing, which may constitute the coefficients of a filter, which filter, when applied to a decoded reconstruction of an input signal would result in the signal having a temporal envelope with an improved resolution. If the spectral estimated spectral coefficients $X[k]_1$ through $X[k]_n$ are incomplete (in the case of decoding estimator providing spectral coefficients for fewer than all input audio signals, for fewer than all time blocks of the input audio signals, and/or for less than all frequency bands), there may not be outputs of each compare 12-1 through 12-n for all time blocks, frequency bands and input signals. The reader should note that $X[k]_1$ through $X[k]_n$ refer to reconstructed outputs, whereas $Y[k]_1$ through $Y[k]_n$ refer to inputs.

The output of each filter calculation 14-1 through 14-n may be applied to the bitstream assembler 10. Although the filter information may be sent separately from the bitstream, preferably it is sent as part of the bitstream and as part of the side information. When aspects of the invention are applied to existing block-based encoding systems, the additional information provided by aspects of the present invention may be inserted in portions of the bitstreams of such systems that are intended to carry auxiliary information.

In practical embodiments, not only the audio information, but also the side information and the filter coefficients will likely be quantized or coded in some way to minimize their transmission cost. However, no quantizing and de-quantizing is shown in the figures for the purposes of simplicity in presentation and because such details are well known and do not aid in an understanding of the invention.

*Wiener Filter Design in the Frequency Domain*

Each of the filter calculation devices or functions 14-1 through 14-n preferably characterizes an FIR filter in the frequency domain that represents the multiplicative changes in the time domain required to obtain a more accurate reproduction of a signal channel's original temporal envelope. This filter problem can be formulated as a least squares problem, which is often referred to as Wiener filter design.. See, for example, X. Rong Li, Probability, Random Signals, and Statistics, CRC Press 1999, New York, pp. 423. Applying Wiener filter techniques has the advantage of reducing the additional bits required to convey the re-shaping filter information to a decoder. Conventional applications of the Wiener filter typically are designed and applied in the time domain.

The frequency-domain least-squares filter design problem may be defined as follows: given the DFT spectral representation of an original signal Y[k] and the DFT spectral representation of an approximation of such original channel X[k], calculate a set of filter coefficients $(a_m)$ that minimize equation 1. Note that Y[k] and X[k] are complex values and thus, in general, $a_m$ will also be complex.

$$\min_{a_m} \left[ E \left| Y[k] - \sum_{m=0}^{M-1} a_m X[k-m] \right|^2 \right], \qquad (1)$$

where $k$ is the spectral index, $E$ is the expectation operator, and $M$ is the length of the filter being designed.

Equation 1 can be re-expressed using matrix expressions as shown in equation 2:

$$\min_{a_m}\left[E\left|\overline{Y}_k - \overline{A}^T \overline{X}_k\right|^2\right],\qquad\qquad (2)$$

where

$$\overline{Y}_k = \left[Y[k]\right]$$

$$\overline{X}_k^T = \left[X[k]\quad X[k-1]\quad\cdots\quad X[k-M+1]\right]$$

and

$$\overline{A}^T = \left[a_0\quad a_1\quad\cdots\quad a_{M-1}\right].$$

Thus, by setting the partial derivatives in equation 2 with respect to each of the filter coefficients to zero, it is simple to show the solution to the minimization problem, which is given by equation 3.

$$\overline{A} = \overline{R}_{XX}^{-1}\,\overline{R}_{XY},\qquad\qquad (3)$$

where

$$\overline{R}_{XX} = \begin{bmatrix} E(X_K X_k^*) & E(X_K X_{k-1}^*) & \cdots & E(X_K X_{k-M+1}^*) \\ E(X_{K-1} X_k^*) & E(X_{K-1} X_{k-1}^*) & \cdots & E(X_{K-1} X_{k-M+2}^*) \\ \vdots & \vdots & \ddots & \vdots \\ E(X_{K-M+1} X_k^*) & E(X_{K-M+1} X_{k-1}^*) & \cdots & E(X_{K-M+1} X_{k-M+1}^*) \end{bmatrix}$$

and

$$\overline{R}_{YX}^T = \left[E(Y_K X_k^*)\quad E(Y_K X_{k-1}^*)\quad\cdots\quad E(Y_K X_{k-M+1}^*)\right].$$

Equation 3 defines the calculation of the optimal filter coefficients that minimize the error between the original spectrum ($Y[k]$) and the reconstructed spectrum ($X[k]$) of a particular channel. Generally, a set of filter coefficients is calculated for every time block of every input signal.

In a practical embodiment of aspects of the invention, a 12th order Wiener filter is employed, although the invention is not limited to the use of a Wiener filter of such size. Such practical embodiment employs processing in the frequency domain following a DFT. Consequently, the Wiener filter coefficients are complex numbers and each filter requires the transmission of twenty-four real numbers. To efficiently convey such filter information to a decoder, vector quantization (VQ) may be used to encode the coefficients of each filter. A codebook may be employed such that only an index need be sent to the decoder to convey the 12th order complex filter information. In a practical embodiment a VQ table codebook having 24 dimensions and 16,536 entries has been found to be useful. The invention is not limited to the use of vector quantization nor the use of a codebook.

While the description above assumes the use of a DFT to estimate the spectral content and to design the Wiener filter, in general any transform may be used.

FIG. 2 shows an example of a decoder or decoding process environment in which aspects of the present invention may be employed. Such an encoder or encoding process may be suitable for operation in cooperation with an encoder or encoding process as described in connection with the example of FIG. 1. An encoded bitstrcam, such as that produced by the arrangement of FIG. 1, is received by any suitable mode of signal transmission or storage and applied to a bitstream unpacker 30 that unpacks the bitstream as necessary to separate the encoded audio information from the side information and yes/no flags (if included in the bitstream). The side information preferably includes a set of filter coefficients for use in improving the reconstruction of each of the one or more of the input signals that were applied to the encoding arrangement of FIG. 1.

In this example, it is assumed that there is a reproduced signal corresponding to each input signal and that temporal envelope re-shaping filter information is provided for every reproduced signal, although this need not be the case, as is mentioned above. Thus, 1 through n sets of filter coefficient side information are shown as output from the bitstream unpacker 30. The filter coefficient information for each input signal is applied to respective re-shaping filters 36-1 through 36-n, whose operation is explained below. Each of the filters may also receive a respective yes/no flag 31-1 through 31-n, indicating whether the filter should be active during a particular time block.

The side information from bitstream packer 30 may also include other information such as, for example, interchannel amplitude differences, interchannel time or phase differences, and interchannel cross-correlation in the case of a binaural cue coding or parametric stereo system. A block-based decoder 42 receives the side information from bitstream unpacker 30 along with the time- to frequency-domain converted audio information from the bitstream unpacker 30. The audio information from the unpacker 30 is applied via a time-domain to frequency-domain converter or conversion function ("T/F") 46, which may be the same as any one of the frequency-domain converters or conversion functions ("T/F") 2-1 through 2-n of FIG. 1.

The block-based decoder 42 provides one or more outputs, each of which is an approximation of a corresponding input signal in FIG. 1. Although some input signals may not have a corresponding output signal, the example of FIG. 2 shows output signals 1 through n, each of which is an approximation corresponding to a respective one of the input signals 1 through n of FIG. 1. In this example, each of the output signals 1 through n of the decoder 42 are applied to a respective re-shaping filter 36-1 through 36-n, each of which may be implemented as an FIR filter. The coefficients of each FIR filter are controlled, on a block basis, by the respective filter information relating to a particular input channel whose reconstructed output is to be improved. Multiplicative envelope reshaping in the time domain preferably is achieved by convolving each FIR filter with a block-based decoder output in each of filters 36-1 through 36-n. Thus, temporal envelope shaping in accordance with the aspects of the present invention takes advantage of the time frequency duality - convolution in the time domain is equivalent to multiplication in the frequency domain and vice versa. Each of the decoded and filtered output signals is then applied to respective frequency-domain to time-domain converters or conversion functions ("F/T") 44-1 through 44-n that each perform the inverse functions of an above-described T/F, namely an inverse FFT, followed by windowing and overlap-add. Alternatively, a suitable time-domain re-shaping filter may be employed following each of the frequency- to time-domain converters. For example, the n polynomial coefficients of an nth order polynomial curvc may be sent as side information instead of FIR filter coefficients and the curve applied by multiplication in the time domain. Although it is preferred to employ Wiener filter techniques to convey the re-shaping filter information to the decoder, other frequency-domain and time-domain techniques may be employed such as those set forth in U.S. Patent application S.N. 10/113,858 of Truman and Vinton, entitled "Broadband Frequency Translation for High Frequency Regeneration," filed March 28, 2002 and published as US 2003/0187663 A1 on October 2, 2003.

*Implementation*

The invention may be implemented in hardware or software, or a combination of both (*e.g.,* programmable logic arrays). Unless otherwise specified, the algorithms included as part of the invention are not inherently related to any particular computer or other apparatus. In particular, various general-purpose machines may be used with programs written in accordance with the teachings herein, or it may be more convenient to construct more specialized apparatus (*e.g.,* integrated circuits) to perform the required method steps. Thus, the invention may be implemented in one or more computer programs executing on one or more programmable computer systems each comprising at least one processor, at least one data storage system (including volatile and non-volatile memory and/or storage elements), at least one input device or port, and at least one output device or port. Program code is applied to input data to perform the functions described herein and generate output information. The output information is applied to one or more output devices, in known fashion.

Each such program may be implemented in any desired computer language (including machine, assembly, or high level procedural, logical, or object oriented programming languages) to communicate with a computer system. In any case, the language may be a compiled or interpreted language.

Each such computer program is preferably stored on or downloaded to a storage media or device (*e.g.,* solid state memory or media, or magnetic or optical media) readable by a general or special purpose programmable computer, for configuring and operating the computer when the storage media or device is read by the computer system to perform the procedures described herein. The inventive system may also be considered to be implemented as a computer-readable storage medium, configured with a computer program, where the storage medium so configured causes a computer system to operate in a specific and predefined manner to perform the functions described herein.

A number of embodiments of the invention have been described. Nevertheless, it will be understood that various modifications may be made without departing from the spirit and scope of the invention. For example, some of the steps described herein may be order independent, and thus can be performed in an order different from that described.

*Background Art*

The following patents, patent applications and publications are relevant for the invention.

AC-3

ATSC Standard A52/A: Digital Audio Compression Standard (AC-3), Revision A, Advanced Television Systems Committee, 20 Aug. 2001. The A/52A document is available on the World Wide Web at http://www.atsc.org/standards.html.
"Design and Implementation of AC-3 Coders," by Steve Vernon, IEEE Trans. Consumer Electronics, Vol. 41, No. 3, August 1995.
"The AC-3 Multichannel Coder" by Mark Davis, Audio Engineering Society Preprint 3774, 95th AES Convention, October, 1993.
"High Quality, Low-Rate Audio Transform Coding for Transmission and Multimedia Applications," by Bosi et al, Audio Engineering Society Preprint 3365, 93rd AES Convention, October, 1992.
United States Patents 5,583,962; 5,632,005; 5,633,981; 5,727,119; and 6,021,386. AAC
ISO/IEC JTC1/SC29, "Information technology - very low bitrate audio-visual coding," ISO/IEC IS-14496 (Part 3, Audio), 1996
1) ISO/IEC 13818-7. "MPEG-2 advanced audio coding, AAC". International Standard, 1997;
M. Bosi, K. Brandenburg, S. Quackenbush, L. Fielder, K. Akagiri, H. Fuchs, M. Dietz, J. Herre, G. Davidson, and Y. Oikawa: "ISO/IEC MPEG-2 Advanced Audio Coding". Proc. of the 101st AES-Convention, 1996;
M. Bosi, K. Brandenburg, S. Quackenbush, L. Fielder, K. Akagiri, H. Fuchs, M. Dietz, J. Herre, G. Davidson, Y. Oikawa: "ISO/IEC MPEG-2 Advanced Audio Coding", Journal of the AES, Vol. 45, No. 10, October 1997, pp. 789-814;
Karlheinz Brandenburg: "MP3 and AAC explained". Proc. of the AES 17th International Conference on High Quality Audio Coding, Florence, Italy, 1999; and
G.A. Soulodre et al.: "Subjective Evaluation of State-of-the-Art Two-Channel Audio Codecs" J. Audio Eng. Soc., Vol. 46, No. 3, pp 164-177, March 1998.

MPEG Intensity Stereo

United States Patents 5,323,396; 5,539,829; 5,606,618 and 5,621,855.
United States Published Patent Application US 2001/0044713, published .

Spatial and Parametric Coding

U.S. Provisional Patent Application S.N. 60/588,256, filed July 14, 2004 of Davis et al, entitled "Low Bit Rate Audio Encoding and Decoding in Which Multiple Channels are Represented By Monophonic Channel and Auxiliary Information."
United States Published Patent Application US 2003/0026441, published February 6, 2003
United States Published Patent Application US 2003/0035553 , published February 20, 2003,
United States Published Patent Application US 2003/0219130 (Baumgarte & Faller) published Nov. 27, 2003,
Audio Engineering Society Paper 5852, March 2003
Published International Patent Application WO 03/090206, published October 30, 2003
Published International Patent Application WO 03/090207, published Oct. 30, 2003
Published International Patent Application WO 03/090208, published October 30, 2003
Published International Patent Application WO 03/007656, published January 22, 2003
United States Published Patent Application Publication US 2003/0236583 A1, Baumgarte et al, published December 25, 2003, "Hybrid Multi-Channel/Cue Coding/Decoding of Audio Signals," Application S.N. 10/246,570.
"Binaural Cue Coding Applied to Stereo and Multi-Channel Audio Compression," by Faller et al, Audio Engineering Society Convention Paper 5574, 112th Convention, Munich, May 2002.
"Why Binaural Cue Coding is Better than Intensity Stereo Coding," by Baumgarte et al, Audio Engineering Society Convention Paper 5575, 112th Convention, Munich, May 2002.

"Design and Evaluatin of Binaural Cue Coding Schemes," by Baumgarte et al, Audio Engineering Society Convention Paper 5706, 113th Convention, Los Angeles, October 2002.

"Efficient Representation of Spatial Audio Using Perceptual Parametrization," by Faller et al, IEEE Workshop on Applications of Signal Processing to Audio and Acoustics 2001, New Paltz, New York, October 2001, pp. 199-202.

"Estimation of Auditory Spatial Cues for Binaural Cue Coding," by Baumgarte et al, Proc. ICASSP 2002, Orlando, Florida, May 2002, pp. II-1801-1804.

"Binaural Cue Coding: A Novel and Efficient Representation of Spatial Audio," by Faller et al, Proc. ICASSP 2002, Orlando, Florida, May 2002, pp. II-1841-II-1844.

"High-quality parametric spatial audio coding at low bitrates," by Breebaart et al, Audio Engineering Society Convention Paper 6072, 116th Convention, Berlin, May 2004.

"Audio Coder Enhancement using Scalable Binaural Cue Coding with Equalized Mixing," by Baumgarte et al, Audio Engineering Society Convention Paper 6060, 116th Convention, Berlin, May 2004.

"Low complexity parametric stereo coding," by Schuijers et al, Audio Engineering Society Convention Paper 6073, 116th Convention, Berlin, May 2004.

"Synthetic Ambience in Parametric Stereo Coding," by Engdegard et al, Audio Engineering Society Convention Paper 6074, 116th Convention, Berlin, May 2004.

Other

U.S. Patent 5,812,971, Herre, "Enhanced Joint Stereo Coding Method Using Temporal Envelope Shaping," September 22, 1998

"Intensity Stereo Coding," by Herre et al, Audio Engineering Society Preprint 3799, 96th Convention, Amsterdam, 1994.

**Claims**

1. A method for audio signal decoding in which one or more input audio signals have been encoded into a bitstream comprising audio information and side information relating to the audio information and useful in decoding the bitstream, wherein each of the one or more input audio signals has been divided into time blocks and at least some of the side information has been updated no more frequently than a block rate, such that the audio information, when decoded using the side information, has a temporal envelope resolution limited by the block rate, wherein the bitstream further includes temporal envelope re-shaping information indicative of a comparison between the temporal envelope of at least one input audio signal and the temporal envelope of an estimated decoded reconstruction of each such at least one input audio signal, which estimated reconstruction employs at least some of the audio information and at least some of the side information, , the method comprising

   receiving (30) the bitstream, and
   decoding (42) the bitstream into one or more decoded reconstructions of the one or more input audio signals, the decoding employing the audio information and the side information; and
   re-shaping (36-1, 36-n) the one or more decoded reconstructions of the one or more input audio signals using said temporal envelope re-shaping information.

2. The method of claim 1 wherein the estimated reconstruction is the same as at least a portion of the decoding.

3. The method according to claim 1 wherein said comparison is performed for one or more time blocks of one or more frequency bands of one or more input audio signals.

4. The method according to claim 3 wherein said comparison is performed for less than all of the audio signals.

5. The method according to claim 3 wherein said comparison is performed for less than all time blocks of an audio signal.

6. The method according to claim 3 wherein said comparison is performed for less than all frequency bands of an audio signal.

7. The method according to any one of claims 1 through 6 wherein some of the temporal envelope re-shaping information is not included in the bitstream.

8. The method according to claim 7 wherein temporal envelope re-shaping information is not included in the bitstream when a measure of the comparison is either greater than or less than a threshold.

9. The method of any one of claims 1 through 8 wherein the side information includes the temporal envelope re-shaping information.

10. The method of any one of claims 1 through 9 wherein re-shaping the one or more decoded reconstructions of the one or more input audio signals using said temporal envelope re-shaping information results in a signal having a temporal envelope with an improved resolution.

11. The method of claim 10, wherein the signal is re-shaped so that it more closely replicates the temporal envelope of the original signal.

12. The method of claim 10 or 11 wherein the improved resolution is a resolution finer than the block rate.

13. The method of any one of claims 1 through 12 wherein a plurality of input audio signals are combined into a composite signal, said audio information is a perceptual-encoding encoded version of the composite signal, and the side information includes one or more parameters indicative of spatial properties of the plurality of input audio signals.

14. The method of any one of claims 1 through 12 wherein a plurality of input audio signals are combined into one or more derived signals, each being derived from one or a combination of ones of at least two input audio signals, said audio information is a perceptual-encoding encoded version of the derived signals, and the side information includes one or more parameters indicative of spatial properties of some or all of the plurality of input audio signals.

15. An audio signal decoder in which one or more input audio signals have been encoded into a bitstream comprising audio information and side information relating to the audio information and useful in decoding the bitstream, wherein each of the one or more input audio signals has been divided into time blocks and at least some of the side information has been updated no more frequently than the block rate, such that the audio information, when decoded using the side information, has a temporal envelope resolution limited by the block rate, wherein the bitstream further includes temporal envelope re-shaping information indicative of a comparison between the temporal envelope of at least one input audio signal and the temporal envelope of an estimated decoded reconstruction of each such at least one input audio signal, which estimated reconstruction employs at least some of the audio information and at least some of the side information, the audio signal decoder comprising

means (30) for receiving the bitstream, and
means (42) for decoding the bitstream into one or more decoded reconstructions of the one or more input audio signals, the decoding employing the audio information and the side information; and
means (36-1, 36-n) for re-shaping the one or more decoded reconstructions of the one or more input audio signals using said temporal envelope re-shaping information.

**Patentansprüche**

1. Verfahren zum Audiosignaldecodieren, wobei ein oder mehrere Eingangsaudiosignale in einen Bitstrom codiert wurden, der Audioinformationen und Seiteninformationen im Zusammenhang mit den Audioinformationen und die beim Decodieren des Bitstroms nützlich sind, umfasst, wobei jedes des einen oder der mehreren Eingangsaudiosignale in Zeitblöcke aufgeteilt wurde, und mindestens etwas der Seiteninformationen nicht häufiger als eine Blockrate aktualisiert wurde, so dass die Audioinformationen, wenn sie unter Verwenden der Seiteninformationen decodiert werden, eine zeitliche Hüllkurvenauflösung aufweisen, die von der Blockrate begrenzt ist, wobei der Bitstrom weiter zeitliche Hüllkurven-Umformungsinformationen beinhaltet, die einen Vergleich zwischen der zeitlichen Hüllkurve und mindestens einem Eingangsaudiosignal angeben, und die zeitliche Hüllkurve einer geschätzten decodierten Rekonstruktion jedes derartigen mindestens einen Eingangsaudiosignals, wobei die geschätzte Rekonstruktion mindestens etwas der Audioinformationen und mindestens etwas der Seiteninformationen einsetzt, wobei das Verfahren umfasst

Empfangen (30) des Bitstroms, und

Decodieren (42) des Bitstroms in eine oder mehrere decodierte Rekonstruktionen des einen oder der mehreren Eingangsaudiosignale, wobei das Decodieren die Audioinformationen und die Seiteninformationen einsetzt; und Umformen (36-1, 36-n) der einen oder mehreren decodierten Rekonstruktionen des einen oder der mehreren Eingangsaudiosignale unter Verwenden der zeitlichen Hüllkurven-Umformungsinformationen.

2.  Verfahren nach Anspruch 1, wobei die geschätzte Rekonstruktion gleich ist wie mindestens ein Abschnitt des Decodierens.

3.  Verfahren nach Anspruch 1, wobei der Vergleich für einen oder mehrere Zeitblöcke eines oder mehrerer Frequenzbänder eines oder mehrerer Eingangsaudiosignale ausgeführt wird.

4.  Verfahren nach Anspruch 3, wobei der Vergleich für weniger als alle der Audiosignale ausgeführt wird.

5.  Verfahren nach Anspruch 3, wobei der Vergleich für weniger als alle Zeitblöcke eines Audiosignals ausgeführt wird.

6.  Verfahren nach Anspruch 3, wobei der Vergleich für weniger als alle Frequenzbänder eines Audiosignals ausgeführt wird.

7.  Verfahren nach einem der Ansprüche 1 bis 6, wobei einige der zeitlichen Hüllkurven-Umformungsinformationen nicht in dem Bitstrom enthalten sind.

8.  Verfahren nach Anspruch 7, wobei Umformungsinformationen der zeitlichen Hüllkurve nicht in dem Bitstrom enthalten sind, wenn eine Messung des Vergleichs entweder größer als oder kleiner als ein Schwellenwert ist.

9.  Verfahren nach einem der Ansprüche 1 bis 8, wobei die Seiteninformationen die Umformungsinformationen der zeitlichen Hüllkurve beinhalten.

10. Verfahren nach einem der Ansprüche 1 bis 9, wobei das Umformen der einen oder mehreren decodierten Rekonstruktionen des einen oder der mehreren Eingangsaudiosignale unter Verwenden der zeitlichen Hüllkurven-Umformungsinformationen in einem Signal resultiert, das eine zeitliche Hüllkurve mit einer verbesserten Auflösung aufweist.

11. Verfahren nach Anspruch 10, wobei das Signal derart ungeformt wird, dass es die zeitliche Hüllkurve des Originalsignals näher repliziert.

12. Verfahren nach Anspruch 10 oder 11, wobei die verbesserte Auflösung eine feinere Auflösung als die Blockrate ist.

13. Verfahren nach einem der Ansprüche 1 bis 12, wobei eine Vielzahl von Eingangsaudiosignalen in ein Summensignal kombiniert wird, wobei die Audioinformationen eine codierte Wahrnehmungscodierungsversion des Summensignals ist, und die Seiteninformationen einen oder mehrere Parameter beinhalten, die räumliche Eigenschaften der Vielzahl von Eingangsaudiosignalen angeben.

14. Verfahren nach einem der Ansprüche 1 bis 12, wobei eine Vielzahl von Eingangsaudiosignalen in ein oder mehrere abgeleitete Signale kombiniert wird, die jeweils von einer oder einer Kombination einiger von mindestens zwei Eingangsaudiosignalen abgeleitet werden, wobei die Audioinformationen eine codierte Wahrnehmungscodierungsversion der abgeleiteten Signale sind, und die Seiteninformationen einen oder mehrere Parameter beinhalten, die räumliche Eigenschaften einiger oder aller der Vielzahl von Eingangsaudiosignalen angeben.

15. Audiosignaldecoder, wobei ein oder mehrere Eingangsaudiosignale in einen Bitstrom codiert wurden, der Audioinformationen und Seiteninformationen im Zusammenhang mit den Audioinformationen und die beim Decodieren des Bitstroms nützlich sind, umfasst, wobei jedes des einen oder der mehreren Eingangsaudiosignale in Zeitblöcke aufgeteilt wurde, und mindestens etwas der Seiteninformationen nicht häufiger als eine Blockrate aktualisiert wurde, so dass die Audioinformationen, wenn sie unter Verwenden der Seiteninformationen decodiert werden, eine zeitliche Hüllkurvenauflösung aufweisen, die von der Blockrate begrenzt ist, wobei der Bitstrom weiter zeitliche Hüllkurven-Umformungsinformationen beinhaltet, die einen Vergleich zwischen der zeitlichen Hüllkurve und mindestens einem Eingangsaudiosignal und die zeitliche Hüllkurve einer geschätzten decodierten Rekonstruktion jedes derartigen mindestens einen Eingangsaudiosignals angeben, wobei die geschätzte Rekonstruktion mindestens etwas der Audioinformationen und mindestens etwas der Seiteninformationen einsetzt, wobei der Audiosignaldecoder umfasst:

Mittel (30) zum Empfangen des Bitstroms, und

Mittel (42) zum Decodieren des Bitstroms in eine oder mehrere decodierte Rekonstruktionen des einen oder der mehreren Eingangsaudiosignale, wobei das Decodieren die Audioinformationen und die Seiteninformationen einsetzt; und

Mittel (36-1, 36-n) zum Umformen der einen oder mehreren decodierten Rekonstruktionen des einen oder der mehreren Eingangsaudiosignale unter Verwenden der zeitlichen Hüllkurven-Umformungsinformationen.

**Revendications**

1. Procédé de décodage de signaux audio dans lequel un ou plusieurs signaux audio d'entrée ont été codés dans un flux binaire comprenant des informations audio et des informations annexes relatives aux informations audio et utiles pour le décodage du flux binaire, dans lequel chacun des un ou plusieurs signaux audio d'entrée a été divisé en blocs temporels et au moins une partie des informations annexes a été mise à jour selon une fréquence non supérieure au débit de bloc, de sorte que les informations audio, une fois décodées en utilisant les informations annexes, présentent une résolution d'enveloppe temporelle limitée par le débit de bloc, dans lequel le flux binaire inclut en outre des informations de reformatage d'enveloppe temporelle indiquant une comparaison entre l'enveloppe temporelle d'au moins un signal audio d'entrée et l'enveloppe temporelle d'une reconstruction décodée estimée de chacun d'un tel au moins un signal audio d'entrée, laquelle reconstruction estimée emploie au moins une partie des informations audio et au moins une partie des informations annexes, le procédé comprenant

   la réception (30) du flux binaire, et

   le décodage (42) du flux binaire en une ou plusieurs reconstructions décodées des un ou plusieurs signaux audio d'entrée, le décodage employant les informations audio et les informations annexes ; et

   le reformatage (36-1, 36-n) des une ou plusieurs reconstructions décodées des un ou plusieurs signaux audio d'entrée en utilisant lesdites informations de reformatage d'enveloppe temporelle.

2. Procédé selon la revendication 1, dans lequel la reconstruction estimée est la même qu'au moins une partie du décodage.

3. Procédé selon la revendication 1, dans lequel ladite comparaison est effectuée pour un ou plusieurs blocs temporels d'une ou de plusieurs bandes de fréquences d'un ou de plusieurs signaux audio d'entrée.

4. Procédé selon la revendication 3, dans lequel ladite comparaison est effectuée pour moins que la totalité des signaux audio.

5. Procédé selon la revendication 3, dans lequel ladite comparaison est effectuée pour moins que la totalité des blocs temporels d'un signal audio.

6. Procédé selon la revendication 3, dans lequel ladite comparaison est effectuée pour moins que la totalité des bandes de fréquences d'un signal audio.

7. Procédé selon l'une quelconque des revendications 1 à 6, dans lequel une partie des informations de reformatage d'enveloppe temporelle n'est pas incluse dans le flux binaire.

8. Procédé selon la revendication 7, dans lequel des informations de reformatage d'enveloppe temporelle ne sont pas incluses dans le flux binaire quand une mesure de la comparaison est soit supérieure, soit inférieure à un seuil.

9. Procédé selon l'une quelconque des revendications 1 à 8, dans lequel les informations annexes incluent les informations de reformatage d'enveloppe temporelle.

10. Procédé selon l'une quelconque des revendications 1 à 9, dans lequel le reformatage des une ou plusieurs reconstructions décodées des un ou plusieurs signaux audio d'entrée en utilisant lesdites informations de reformatage d'enveloppe temporelle donne un signal présentant une enveloppe temporelle à résolution améliorée.

11. Procédé selon la revendication 10, dans lequel le signal est reformaté pour qu'il réplique plus fidèlement l'enveloppe temporelle du signal d'origine.

**12.** Procédé selon la revendication 10 ou 11, dans lequel la résolution améliorée est une résolution plus fine que le débit de bloc.

**13.** Procédé selon l'une quelconque des revendications 1 à 12, dans lequel une pluralité de signaux audio d'entrée sont combinés dans un signal composite, lesdites informations audio sont une version codée à codage perceptuel du signal composite, et les informations annexes incluent un ou plusieurs paramètres indiquant des propriétés spatiales de la pluralité de signaux audio d'entrée.

**14.** Procédé selon l'une quelconque des revendications 1 à 12, dans lequel une pluralité de signaux audio d'entrée sont combinés dans un ou plusieurs signaux dérivés, chacun étant dérivé d'un ou d'une combinaison d'au moins deux signaux audio d'entrée, lesdites informations audio sont une version codée à codage perceptuel des signaux dérivés, et les informations annexes incluent un ou plusieurs paramètres indiquant des propriétés spatiales de certains ou de la totalité de la pluralité de signaux audio d'entrée.

**15.** Décodeur de signaux audio dans lequel un ou plusieurs signaux audio d'entrée ont été codés dans un flux binaire comprenant des informations audio et des informations annexes relatives aux informations audio et utiles pour le décodage du flux binaire, dans lequel chacun des un ou plusieurs signaux audio d'entrée a été divisé en blocs temporels et au moins une partie des informations annexes a été mise à jour selon une fréquence non supérieure au débit de bloc, de sorte que les informations audio, une fois décodées en utilisant les informations annexes, présentent une résolution d'enveloppe temporelle limitée par le débit de bloc, dans lequel le flux binaire inclut en outre des informations de reformatage d'enveloppe temporelle indiquant une comparaison entre l'enveloppe temporelle d'au moins un signal audio d'entrée et l'enveloppe temporelle d'une reconstruction décodée estimée de chacun d'un tel au moins un signal audio d'entrée, laquelle reconstruction estimée emploie au moins une partie des informations audio et au moins une partie des informations annexes, le décodeur de signaux audio comprenant

des moyens (30) pour recevoir le flux binaire, et
des moyens (42) pour décoder le flux binaire en une ou plusieurs reconstructions décodées des un ou plusieurs signaux audio d'entrée, le décodage employant les informations audio et les informations annexes ; et
des moyens (36-1, 36-n) pour reformater les une ou plusieurs reconstructions décodées des un ou plusieurs signaux audio d'entrée en utilisant lesdites informations de reformatage d'enveloppe temporelle.

*FIG. 1*

FIG. 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 58825604, Davis
- US 11385802, Truman and Vinton
- US 20030187663 A1
- US 5583962 A
- US 5632005 A
- US 5633981 A
- US 5727119 A
- US 6021386 A
- US 5323396 A
- US 5539829 A
- US 5606618 A
- US 5621855 A

- US 20010044713 A
- US 20030026441 A
- US 20030035553 A
- US 20030219130 A, Baumgarte & Faller
- WO 03090206 A
- WO 03090207 A
- WO 03090208 A
- WO 03007656 A
- US 20030236583 A1, Baumgarte
- US 10246570 B
- US 5812971 A, Herre

### Non-patent literature cited in the description

- **X. RONG LI.** Probability, Random Signals, and Statistics,. CRC Press, 1999, 423
- ATSC Standard A52/A: Digital Audio Compression Standard (AC-3), Revision A. *Advanced Television Systems Committee,* 20 August 2001, http://www.atsc.org/standards.html
- **STEVE VERNON.** Design and Implementation of AC-3 Coders. *IEEE Trans. Consumer Electronics,* August 1995, vol. 41 (3
- **MARK DAVIS.** The AC-3 Multichannel Coder. Audio Engineering Society Preprint 3774, October 1993
- **BOSI et al.** High Quality, Low-Rate Audio Transform Coding for Transmission and Multimedia Applications. Audio Engineering Society Preprint 3365, October 1992
- Information technology - very low bitrate audio-visual coding. *ISO/IEC IS-14496 (Part 3, Audio),* 1996
- MPEG-2 advanced audio coding, AAC. *International Standard,* 1997
- **M. BOSI ; K. BRANDENBURG ; S. QUACKENBUSH ; L. FIELDER ; K. AKAGIRI ; H. FUCHS ; M. DIETZ ; J. HERRE ; G. DAVIDSON ; Y. OIKAWA.** ISO/IEC MPEG-2 Advanced Audio Coding. *Proc. of the 101st AES-Convention,* 1996
- **M. BOSI ; K. BRANDENBURG ; S. QUACKENBUSH ; L. FIELDER ; K. AKAGIRI ; H. FUCHS ; M. DIETZ ; J. HERRE ; G. DAVIDSON ; Y. OIKAWA.** ISO/IEC MPEG-2 Advanced Audio Coding. *Journal of the AES,* October 1997, vol. 45 (10), 789-814

- **KARLHEINZ BRANDENBURG.** MP3 and AAC explained. *Proc. of the AES 17th International Conference on High Quality Audio Coding,* 1999
- **G.A. SOULODRE et al.** J. Audio Eng. Soc. *Subjective Evaluation of State-of-the-Art Two-Channel Audio Codecs,* March 1998, vol. 46 (3), 164-177
- *Audio Engineering Society Paper 5852,* March 2003
- **FALLER et al.** Binaural Cue Coding Applied to Stereo and Multi-Channel Audio Compression. *Audio Engineering Society Convention Paper 5574, 112th Convention,* May 2002
- **BAUMGARTE et al.** Why Binaural Cue Coding is Better than Intensity Stereo Coding. *Audio Engineering Society Convention Paper 5575, 112th Convention,* May 2002
- **BAUMGARTE et al.** Design and Evaluatin of Binaural Cue Coding Schemes. *Audio Engineering Society Convention Paper 5706, 113th Convention,* October 2002
- **FALLER et al.** Efficient Representation of Spatial Audio Using Perceptual Parametrization. *IEEE Workshop on Applications of Signal Processing to Audio and Acoustics,* October 2001, 199-202
- **BAUMGARTE et al.** Estimation of Auditory Spatial Cues for Binaural Cue Coding. *Proc. ICASSP,* May 2002, II-1801-1804
- **FALLER et al.** Binaural Cue Coding: A Novel and Efficient Representation of Spatial Audio. *Proc. ICASSP,* May 2002, II-1841-II-1844

- **BREEBAART et al.** High-quality parametric spatial audio coding at low bitrates. *Audio Engineering Society Convention Paper 6072, 116th Convention,* May 2004
- **BAUMGARTE et al.** Audio Coder Enhancement using Scalable Binaural Cue Coding with Equalized Mixing. *Audio Engineering Society Convention Paper 6060, 116th Convention,* May 2004
- **SCHUIJERS et al.** Low complexity parametric stereo coding. *Audio Engineering Society Convention Paper 6073, 116th Convention,* May 2004
- **ENGDEGARD et al.** Synthetic Ambience in Parametric Stereo Coding. *Audio Engineering Society Convention Paper 6074, 116th Convention,* May 2004
- **HERRE et al.** Intensity Stereo Coding. *Audio Engineering Society Preprint 3799, 96th Convention,* 1994